# EUROPEAN PATENT APPLICATION

(11) **EP 4 304 305 A1**
(43) Date of publication of application: **10.01.2024**
(21) Application number: 21930915.0
(22) Date of filing: 19.03.2021
(51) Int. Cl.: H05K 3/34, H05K 1/18, H01L 23/488

(54) **PACKAGE ASSEMBLY AND ELECTRONIC DEVICE**

(71) Applicant: Huawei Technologies Co., Ltd., Shenzhen, Guangdong 518129 (CN)
(72) Inventor: GAN, Liyun, Shenzhen, Guangdong 518129 (CN); ZENG, Le, Shenzhen, Guangdong 518129 (CN); LIU, Zhiyu, Shenzhen, Guangdong 518129 (CN); MA, Zhifeng, Shenzhen, Guangdong 518129 (CN); ZHANG, Tong, Shenzhen, Guangdong 518129 (CN)
(74) Representative: Pfenning, Meinig & Partner mbB
(86) International application number: PCT/CN2021/081926
(87) International publication number: WO 2022/193326

(57) **Abstract**

Embodiments of this application disclose a packaging assembly and an electronic device. The packaging assembly includes: a substrate and a chip, where the substrate includes a first surface and a second surface that are opposite to each other, the first surface of the substrate is opposite to a surface of the chip, a plurality of electrodes are disposed on the first surface of the substrate, a signal transmission port is disposed on the second surface of the substrate, and the signal transmission port is electrically connected to the electrode; and a plurality of pads are disposed on the surface of the chip opposite to the substrate, and the pads are soldered and connected to the electrodes through a plurality of conductive connection portions, where one pad is connected to the plurality of conductive connection portions, and the plurality of conductive connection portions are electrically connected to one signal transmission port. Therefore, the plurality of conductive connection portions are disposed on a single pad, so that stress may be evenly distributed to the plurality of conductive connection portions. This improves reliability of a component. In addition, the plurality of conductive connection portions connected to one pad back up each other's performance. This provides a plurality of performance guarantees, and improves electrical connection stability.

## Description

### TECHNICAL FIELD

Embodiments of this application relate to the field of appliance devices, and in particular, to a packaging assembly and an electronic device.

### BACKGROUND

A chip scale package (Chip Scale Package, CSP) may be used in a surface acoustic wave filter (Surface Acoustic Wave Filter, SAW filter), a film bulk acoustic resonator filter (Film Bulk Acoustic Resonator Filter, FBAR filter), and a bulk acoustic wave filter (Bulk Acoustic Wave Filter, BAW filter). The chip scale package may not only greatly reduce a chip (Die) package area, but also enhance anti-interference and anti-noise performance of the chip.

A packaging assembly includes: a housing 40, a chip, and a substrate that are stacked. The housing 40 and the substrate enclose a first cavity, and the chip is located in the first cavity. The chip may be soldered and connected to the substrate through a conductive connection portion, to implement input/output of electrical performance of the chip and grounding.

Currently, in some solutions, a tin ball is used as the conductive connection portion. However, a bubble exists in a solder flux or a tin paste in the tin ball, and a hole is easily generated in a process of forming the conductive connection portion. This affects reliability of the entire conductive connection portion.

In other solutions, a gold ball is used as the conductive connection portion, and ultrasonic melting may be performed on the gold ball on the chip through a gold wire, to form the conductive connection portion. Next, the chip may be inverted on the substrate for ultrasonic soldering. This resolves a problem of the hole in the conductive connection portion.

However, the gold ball has a problem of temperature cycling reliability. When temperature rises or decreases, a thermal expansion coefficient mismatch among the chip, the conductive connection portion, and the substrate affects stability of electrical connection.

Accordingly, it is necessary to provide an improved packaging assembly.

### SUMMARY

Embodiments of this application provide a packaging assembly and an electronic device, to resolve a problem of poor connection stability of the packaging assembly.

To achieve the foregoing objectives, the following technical solutions are used in embodiments of this application. According to a first aspect, embodiments of this application provide a packaging assembly, including: a substrate and a chip, where the substrate includes a first surface and a second surface that are opposite to each other, the first surface of the substrate is opposite to a surface of the chip, a plurality of electrodes are disposed on the first surface of the substrate, a signal transmission port is disposed on the second surface of the substrate, and the signal transmission port is electrically connected to the electrode; and a first pad is disposed on the surface of the chip opposite to the substrate, and the first pad is soldered and connected to the electrode through a conductive connection portion, where one first pad is connected to a plurality of conductive connection portions. Therefore, a plurality of electrical connectors are disposed on a single pad, and the pad may evenly distribute stress to the plurality of electrical connectors. This reduces the stress on the single electrical connector, and improves reliability of a component.

In an optional implementation, the plurality of conductive connection portions connected to one first pad are connected to one signal transmission port. Therefore, the plurality of conductive connection portions connected to one pad are electrically connected to one signal transmission port, so that electrical performance of the plurality of electrical connectors connected to one pad is the same, and the plurality of electrical connector back up each other's performance. This provides a plurality of performance guarantees, and improves electrical connection stability.

In an optional implementation, that the plurality of conductive connection portions are connected to one signal transmission port includes: The plurality of conductive connection portions are electrically connected to one electrode, and are connected to one signal transmission port through one electrode. Therefore, the plurality of electrical connectors connected to one first pad are interconnected on the first surface of the substrate through the electrode. This implements electrical performance backup of the component.

In an optional implementation, that the plurality of conductive connection portions are connected to one signal transmission port includes: A plurality of plated through holes are provided in the substrate, and the plurality of conductive connection portions are respectively soldered and connected to the plurality of electrodes, and the plurality of electrodes are respectively electrically connected to one signal transmission port through the plurality of plated through holes. Therefore, the plurality of electrical connectors connected to one pad are interconnected on the second surface of the substrate through the signal transmission port. This implements electrical performance backup of the component.

In an optional implementation, the plurality of plated through holes are combined into one path in the substrate, and are electrically connected to one signal transmission port. Therefore, the plurality of electrical connectors connected to one pad are interconnected in the substrate through the plated through holes. This implements electrical performance backup of the component.

In an optional implementation, a distance between adjacent conductive connection portions in the plurality of conductive connection portions is less than or equal to a diameter of a single conductive connection portion. Therefore, arrangement density of the conductive connection portions may be improved, stress on a single electrical connector may be reduced, and reliability of the component may be improved.

In an optional implementation, the first pad is in a shape of a circle or a polygon. Therefore, a setting manner of the pad is more flexible, and a shape of the chip is easily adapted.

In an optional implementation, connection lines of centers of the plurality of conductive connection portions connected to one first pad are arranged in a shape of a straight line, a broken line, or a polygon. Therefore, the conductive connection portions are flexibly arranged, which is convenient to adapt to shapes of different pad.

In an optional implementation, the conductive connection portion is in a shape of a sphere, an ellipse, a cube, or a polyhedron. Therefore, the shape of the conductive connection portion is more flexible, and internal space of the packaging assembly may be fully used.

In an optional implementation, the conductive connection portion is made of metal or an alloy material. Therefore, a plurality of materials of the conductive connection portions are available, and processing is convenient.

In an optional implementation, the method further includes: A second pad is disposed on the surface of the chip, a support component is disposed between the chip and the substrate, one end of the support component is connected to the second pad, the other end of the support component is connected to the electrode, and the support component is not connected to the signal transmission port. A forming process of the support component is the same as a forming process of the conductive connection portion. Therefore, because a same process is used for the conductive connection portion and the support component, a height of the conductive connection portion and a height of the support component are the same, so that the conductive connection portion and the substrate may be effectively contacted to complete a connection. This avoids generating a gap, and improves stability of the component.

In an optional implementation, the support component is disposed in a peripheral area of the chip, an area enclosed by a first pad connected to the signal transmission port is an effective area, and an area between the effective area and an edge of the chip is the peripheral area of the chip. Therefore, the support component is disposed in the peripheral area of the chip, and may effectively support the chip and distribute stress on the peripheral area of the chip.

In an optional implementation, the support component is spaced apart from the conductive connection portion. Therefore, stress on the effective area of the chip may be effectively distributed.

In an optional implementation, the support component is in a shape of a sphere, an ellipse, a cube, or a polyhedron. Therefore, the shape of the support component is more flexible, and internal space of the packaging assembly may be fully used.

In an optional implementation, the support component is made of metal or an alloy material. Therefore, a plurality of materials are available, and processing is convenient.

In an optional implementation, the packaging assembly further includes a housing, the housing and the first surface of the substrate enclose a first cavity, and the chip is located in the first cavity. Therefore, the housing may isolate the chip from the outside, and interference caused by an external environment to the chip may be avoided.

In an optional implementation, the housing includes: a bracket and a cover plate, where the bracket is located on the first surface of the substrate and surrounds the chip, and the cover plate is disposed on a top of the bracket. Therefore, the housing and the substrate may enclose a cavity, to protect the chip.

According to a first aspect, embodiments of this application provide an electronic device, where the electronic device includes a circuit board and the packaging assembly described above, and a signal transmission port of the packaging assembly is soldered on the circuit board. Therefore, the electronic device uses the packaging assembly. This improves component reliability and electrical connection stability.

### BRIEF DESCRIPTION OF DRAWINGS

FIG. 1 is a schematic diagram of a structure of a packaging assembly;
FIG. 2 is a schematic arrangement diagram of conductive connection portions on a chip;
FIG. 3 is a simulation diagram of accumulated viscoplastic strain of each conductive connection portion in FIG. 2;
FIG. 4 is a schematic diagram of performing a crimping test on a packaging assembly;
FIG. 5 is a schematic diagram of a structure of a packaging assembly according to an embodiment of this application;
FIG. 6 is a schematic diagram of a structure of a surface of a chip in FIG. 5;
FIG. 7 is a top view of a first surface of a substrate in FIG. 5;
FIG. 8 is a schematic diagram of an arrangement manner of conductive connection portions according to an embodiment of this application;
FIG. 9 is a schematic diagram of another arrangement manner of conductive connection portions according to an embodiment of this application;
FIG. 10 is a schematic diagram of another arrangement manner of conductive connection portions according to an embodiment of this application;
FIG. 11 is a cross-sectional view of a conductive connection portion according to an embodiment of this application;
FIG. 12 is a schematic diagram of a structure of another surface of a chip according to an embodiment of this application;
FIG. 13 is a simulation diagram of accumulated viscoplastic strain of each conductive connection portion in FIG. 12;
FIG. 14 is a schematic diagram of a structure of another packaging assembly according to an embodiment of this application;
FIG. 15 is a schematic diagram of a structure of another packaging assembly according to an embodiment of this application;
FIG. 16 is a schematic diagram of a structure of another packaging assembly according to an embodiment of this application;
FIG. 17 is a schematic diagram of a structure of another packaging assembly;
FIG. 18 is a schematic diagram of a structure of a first surface of a substrate in FIG. 17;
FIG. 19 is a schematic diagram of a connection status of a conductive connection portion in FIG. 17;
FIG. 20 is a schematic diagram of a structure of another packaging assembly according to an embodiment of this application;
FIG. 21 is a schematic diagram of a structure of a surface of a chip in FIG. 20;
FIG. 22 is a schematic diagram of a structure of a first surface of a substrate in FIG. 20;
FIG. 23 is a schematic arrangement diagram of a conductive connection portion in FIG. 20;
FIG. 24 is a schematic arrangement diagram of another conductive connection portion in FIG. 20;
FIG. 25 is a simulation diagram of accumulated viscoplastic strain of each conductive connection portion in FIG. 21;
FIG. 26 is a simulation diagram of compressive performance of each conductive connection portion without a support component;
FIG. 27 is a simulation diagram of compressive performance of each conductive connection portion when there is a support component at an outer ring in a peripheral area; and
FIG. 28 is a schematic diagram of a structure of an electronic device according to an embodiment of this application.

### DESCRIPTION OF EMBODIMENTS

The following describes implementations of embodiments of this application in detail with reference to the accompanying drawings.

The terms "first" and "second" mentioned below are merely intended for a purpose of description, and shall not be understood as an indication or implication of relative importance or implicit indication of the quantity of indicated technical features. Therefore, a feature defined by "first" or "second" can explicitly or implicitly includes one or more features. In description of this application, unless otherwise stated, "a plurality of" means two or more than two.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

The following describes possible terms in embodiments of this application.

Pad (Pad): a closed area in which metal layers on a die (Die) are connected to each other and formed. After ball planting may be performed on a chip pad (Chip Pad), a soldering ball is connected to electrodes on a substrate to implement input/output of electrical signals or grounding.

Die (Die): a small piece on a wafer (Wafer) that becomes a particle when packaged. Using a silicon process as an example, generally an entire silicon chip is the wafer, and each unit is diced and packaged, where a single unit before packaging is the die.

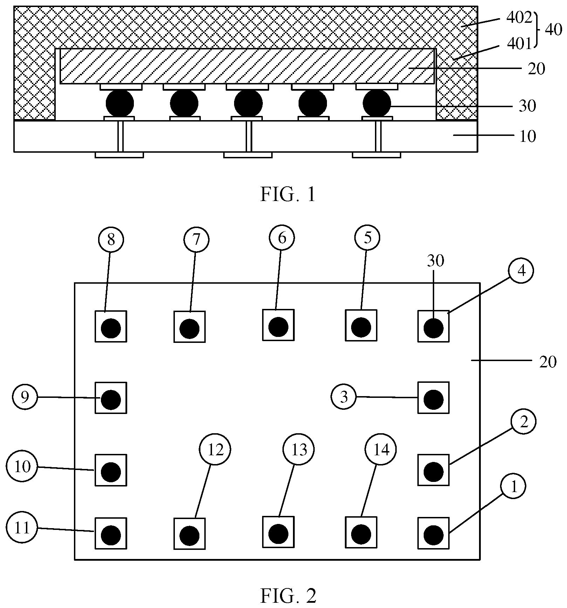

FIG. 1 is a schematic diagram of a structure of a packaging assembly. As shown in FIG. 1, the packaging assembly includes: a housing 40, a chip 20, and a substrate 10 that are stacked. The housing 40 and the substrate 10 enclose a first cavity, and the chip 20 is located in the first cavity. The chip 20 may be soldered and connected to the substrate 10 through a conductive connection portion 30, to implement input/output of electrical performance of the chip 20 and grounding.

A structure of the housing 40 is not limited in embodiments of this application. The housing 40 includes: a bracket 401 and a cover plate 402, where the bracket 401 is located on a first surface of the substrate 10 and surrounds the chip 20, and the cover plate 402 is disposed on a top of the bracket 401.

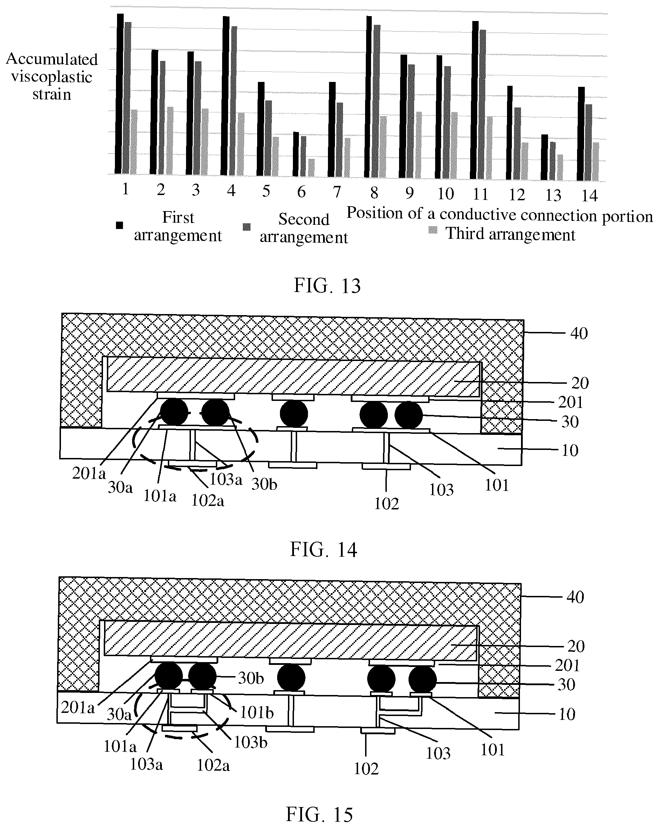

FIG. 2 is a schematic arrangement diagram of conductive connection portions on a chip. As shown in FIG. 2, 14 conductive connection portions 30 are disposed on a surface of the chip 20, and are respectively disposed at a position ①, a position ②, a position ③, a position ④, a position ⑤, a position ⑥, a position ⑦, a position ⑧, a position ⑨, a position ⑩, a position ⑪, a position ⑫, a position (13), and a position ⑭ on the surface of the chip 20.

In some embodiments, a tin ball may be used as a conductive connection portion 30. However, a bubble exists in a solder flux or a tin paste in the tin ball, and a hole is easily generated in a process of forming the conductive connection portion 30. This affects reliability of the conductive connection portion 30.

In some other embodiments, a gold ball may be used as the conductive connection portion 30, and ultrasonic melting may be performed on the gold ball on the chip 20 through a gold wire, to form the conductive connection portion 30. Then, the chip 20 may be inverted on the substrate 10 for ultrasonic soldering. This resolves a problem of the hole in the conductive connection portion 30. However, a size of the gold ball is small, which affects reliability of the conductive connection portion 30.

A size of the conductive connection portion 30 is not limited in embodiments of this application. When the tin ball is used as the conductive connection portion 30, a diameter of the conductive connection portion 30 is usually 150 µm, and a height of the conductive connection portion 30 is 65 µm.

When the gold ball is used as the conductive connection portion 30, a diameter of the conductive connection portion 30 is usually 100 µm, and a height of the conductive connection portion 30 is 20 µm.

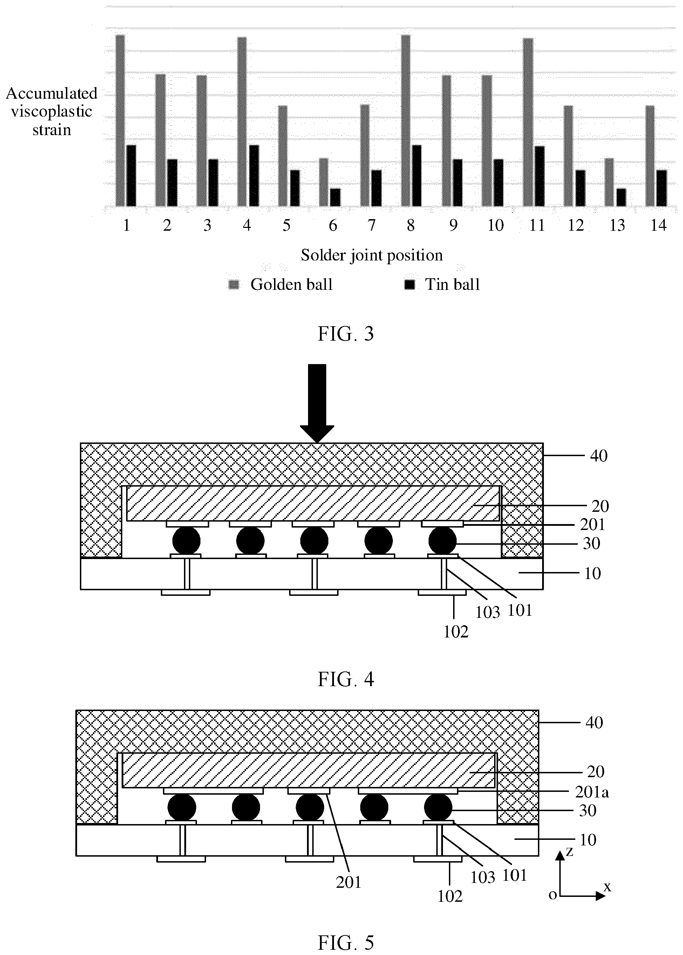

FIG. 3 is a simulation diagram of accumulated viscoplastic strain of each conductive connection portion 30 in FIG. 2 during a high and low temperature cycle (-55 to +125°C). FIG. 3 shows the accumulated viscoplastic strain of each conductive connection portion 30 when a gold ball is used as each conductive connection portion 30 at a position ① to a position ⑭ on a surface of the chip 20, and the accumulated viscoplastic strain of each conductive connection portion 30 when a tin ball is used as the conductive connection portion 30 at the position ① to the position ⑭ on the surface of the chip 20.

As shown in FIG. 3, when the gold ball is used as the conductive connection portion 30, the accumulated viscoplastic strain of each conductive connection portion 30 is large, and when the tin ball is used as the conductive connection portion 30, the accumulated viscoplastic strain of each conductive connection portion 30 is small. When the gold ball is used as the conductive connection portion 30, reliability of the packaging assembly is low.

As shown in FIG. 4, in a factory test phase, a crimping test needs to be performed on the packaging assembly 20. When the tin ball is used as the conductive connection portion 30, a hole exists inside the conductive connection portion 30, and reliability is poor. When the gold ball is used as the conductive connection portion 30, a size of the conductive connection portion 30 is small, and the reliability is poor. The crimping test may cause damage to the conductive connection portion 30 or the chip 20, which affects product performance.

Therefore, embodiments of this application provide an improved packaging assembly, to improve reliability of the conductive connection portion 30.

As shown in FIG. 5, the packaging assembly includes: a substrate 10 and a chip 20. The substrate 10 and the chip 20 are stacked in a z direction.

The substrate 10 includes a first surface and a second surface that are opposite to each other. For example, the first surface of the substrate 10 is opposite to a surface of the chip 20.

It should be noted that the first surface of the substrate 10 is an upper surface of the substrate 10 in FIG. 5, the second surface of the substrate 10 is a lower surface of the substrate 10 in FIG. 5, and the surface of the chip 20 is a lower surface of the chip 20 in FIG. 2.

A plurality of electrodes 101 are disposed on the first surface of the substrate 10, a plurality of signal transmission ports 102 are disposed on the second surface of the substrate 10, and the signal transmission ports 102 are connected to the electrodes 101.

A connection manner between the signal transmission ports 102 and the electrodes 101 is not limited in embodiments of this application. In some embodiments, the signal transmission port 102 may be connected to the electrode 101 through a plated through hole 103, and the signal transmission port 102 may input or output an electrical signal to the electrode 101 through the plated through hole 103.

A plurality of pads 201 are disposed on the surface of the chip 20, and the electrode 101 is connected to the pad 201 through a conductive connection portion 30. Therefore, the electrode 101 may further perform signal transmission between the pad 201 and the chip 20, so that the chip 20 may perform signal transmission or implement grounding through the signal transmission port 102.

It should be noted that a use scope of the conductive connection portion 30 is not limited in embodiments of this application. The conductive connection portion 30 may be further configured to implement interconnection between a die (die) and a wafer (wafer), between wafers, between dies, between the wafer and a substrate, between the die and the substrate, or between substrates.

At least one of the pads 201 is connected to a plurality of conductive connection portions 30.

It should be noted that for example, the plurality of pads 201 are disposed on the chip 20. That at least one pad 201 is connected to the plurality of conductive connection portions 30 means that one or more pads 201 in the plurality of pads 201 are connected to the plurality of conductive connection portions 30.

For example, as shown in FIG. 5, a pad 201a on the second surface of the chip 20 is simultaneously connected to two conductive connection portions 30.

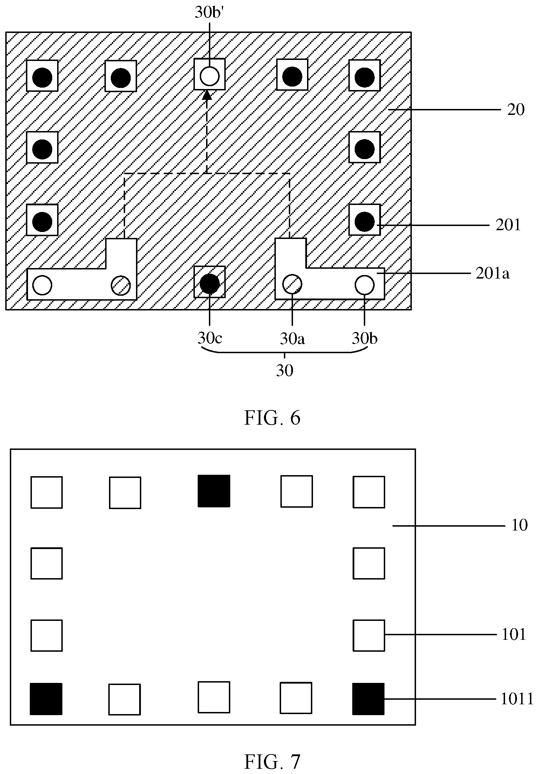

FIG. 6 is a top view of a second surface of a chip 20. As shown in FIG. 6, a conductive connection portion 30a and a conductive connection portion 30b are connected to one pad 201a at a lower right corner of the chip 20.

Therefore, the pad 201a may evenly distribute stress on the conductive connection portion 30a and the conductive connection portion 30b that are connected to the pad 201a. This may reduce stress on a single electrical connector, and improve reliability of a component.

Certainly, in some other embodiments of this application, each pad may be connected to a plurality of conductive connection portions 30. All these fall within a protection scope of this application.

In addition, it should be noted that when one pad 201 is connected to the plurality of conductive connection portions 30, a quantity of conductive connection portions 30 is not limited, and there may be two or more conductive connection portions 30.

Therefore, a plurality of electrical connectors are disposed on a single pad 201, and the pad 201 may evenly distribute stress to the plurality of electrical connectors. This reduces the stress on the single electrical connector, and improves reliability of a component.

FIG. 7 is a top view of a first surface of a substrate 10. As shown in FIG. 7, an electrode 101 includes: a first electrode 1011 configured to be connected to a signal end.

Referring to FIG. 6, a conductive connection portion 30 includes: a conductive connection portion 30c configured to be connected to a ground end, a conductive connection portion 30b and a conductive connection portion 30b' that are configured to be connected to a signal end, and a conductive connection portion 30a used for supporting only.

The conductive connection portion 30 shown in FIG. 6 and the electrode 101 shown in FIG. 7 are in a one-to-one correspondence. The conductive connection portion 30b is configured to be connected to the first electrode 1011.

Therefore, the first electrode 101 may transmit a signal at a signal input end to the conductive connection portion 30b, transmit the signal to the chip 20 through the conductive connection portion 30b, and finally output the signal through the conductive connection portion 30b'.

A material of the conductive connection portion 30 is not limited in embodiments of this application, and the conductive connection portion 30 may be made of any metal or alloy material. In some embodiments of this application, the conductive connection portion 30 may be made of tin or gold.

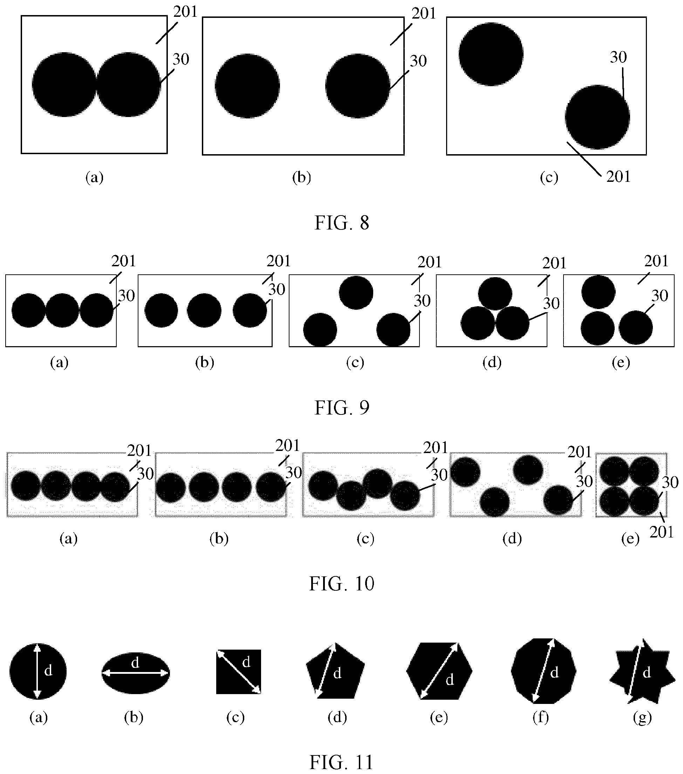

An arrangement manner of the plurality of conductive connection portions 30 is not limited in embodiments of this application. As shown in FIG. 8, FIG. 9, and FIG. 10, connection lines of centers of the plurality of conductive connection portions 30 connected to one pad 201 are arranged in a shape of a straight line, a broken line, or a polygon.

In some embodiments, as shown in FIG. 8, there are two conductive connection portions 30 connected to one pad 201, and the two conductive connection portions 30 may be disposed side by side and consecutively as shown in (a) in FIG. 8, or are spaced apart as shown in (b) and (c) in FIG. 8. As shown in (c) in FIG. 8, the conductive connection portions 30 are spaced apart along a diagonal of the pad 201.

In some embodiments, as shown in FIG. 9, there are three conductive connection portions 30 connected to one pad 201, and the three conductive connection portions 30 may be disposed side by side and continuously as shown in (a) in FIG. 9, or are spaced apart as shown in (b), (c), and (e) in FIG. 9, or are stacked as shown in (d) in FIG. 9. Connection lines of centers of the conductive connection portions 30 in (a) and (b) in FIG. 9 are arranged in a shape of a straight line, and surfaces of the three conductive connection portions 30 in (a) and (d) in FIG. 9 are tangential. Connection lines of centers of the conductive connection portions 30 in (c), (d), and (e) in FIG. 9 are arranged in a shape of a triangle.

In some embodiments, as shown in FIG. 10, there are four conductive connection portions 30 connected to one pad 201, and the four conductive connection portions 30 may be disposed side by side as shown in (a) in FIG. 10, or are spaced apart as shown in (b) and (d) in FIG. 10. Connection lines of centers of the conductive connection portions 30 in (a) and (b) in FIG. 10 are arranged in a shape of a straight line, or are stacked as shown in (c) and (e) in FIG. 10, to be specific, arranged in tangential manner in a plane. Connection lines of centers of the conductive connection portions 30 in (c) in FIG. 10 are arranged in a shape of a fold line, and connection lines of centers of the conductive connection portions 30 in (d) and (e) in FIG. 10 are arranged in a shape of a quadrilateral.

In some embodiments, a distance between adjacent conductive connection portions 30 in a plurality of conductive connection portions 30 connected to one pad 201 is less than or equal to a diameter of a single conductive connection portion 30.

It should be noted that as shown in (a), (b), (c), (d), (e), (f), and (g) in FIG. 11, a diameter d of the single conductive connection portion 30 may be defined as a distance between the furthest points on a surface of the single conductive connection portion 30.

A shape of the conductive connection portion 30 is not limited in embodiments of this application. The shape of the conductive connection portion 30 may be a sphere, an ellipsoid, a cube, a polyhedron, or another irregular shape.

In some embodiments, as shown in FIG. 11, a cross-sectional shape of the conductive connection portion 30 may be a circle, an ellipse, a quadrilateral, a pentagon, a hexagon, a decagon, a heptagonal star, or the like.

The shape of the conductive connection portion 30 is merely an example for description. This is not limited in embodiments of this application.

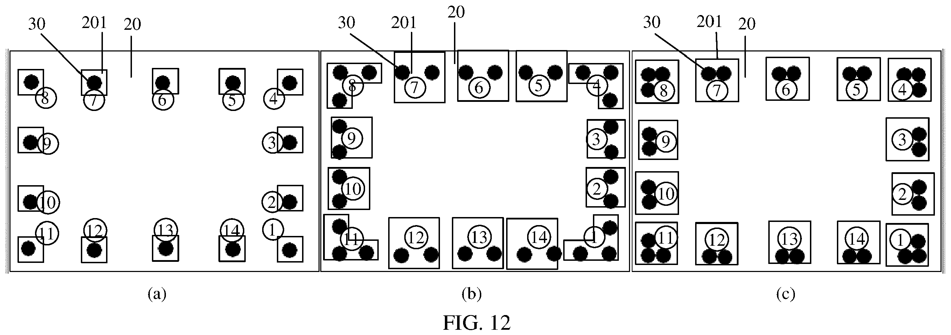

FIG. 12 is a schematic diagram of an arrangement manner of conductive connection portions 30 according to an embodiment of this application. As shown in (a) in FIG. 12, one conductive connection portion 30 is disposed on each pad 201, and the conductive connection portion 30 is located at a middle position of the pad 201. This arrangement manner is referred to as first arrangement for short.

As shown in (b) in FIG. 12, three conductive connection portions 30 are respectively disposed on the pads 201 at four corners of a chip 20, and the three conductive connection portions 30 are spaced apart.

Two conductive connection portions 30 are respectively disposed on the pads 201 on four sides of the chip 20, and the two conductive connection portions 30 are spaced apart. The arrangement manner is referred to as second arrangement for short. When the second arrangement is used, a distance d between adjacent conductive connection portions 30 is equal to a diameter of the single conductive connection portion 30.

As shown in (c) in FIG. 12, three conductive connection portions 30 are respectively disposed on the pads 201 at the four corners of the chip 20, the three conductive connection portions 30 are stacked, and the adjacent conductive connection portions 30 are tangent.

Two conductive connection portions 30 are respectively disposed on the pads 201 on the four sides of the chip 20, and the two conductive connection portions 30 are tangent. The arrangement manner is referred to as the third arrangement for short. When the third arrangement is used, a distance d between adjacent conductive connection portions 30 is less than a diameter of the single conductive connection portion 30.

As shown in (c) in FIG. 12, the distance d between the adjacent conductive connection portions 30 is 0.

FIG. 13 is a simulation diagram of accumulated viscoplastic strain of each conductive connection portion in FIG. 12 during a high and low temperature cycle (for example, -55 to +125°C). FIG. 13 shows the accumulated viscoplastic strain of the packaging assembly when the conductive connection portions 30 at a position ① to a position ⑭ use the first arrangement shown in (a) in FIG. 12, the conductive connection portions 30 at the position ① to the position ⑭ use the second arrangement shown in (b) in FIG. 12, and the conductive connection portions 30 at the position ① to the position ⑭ use the third arrangement shown in (c) in FIG. 12.

As shown in FIG. 13, when the conductive connection portions 30 at the position ① to the position ⑭ use the first arrangement, accumulated viscoplastic strain performance of the conductive connection portions is the worst.

When the conductive connection portions 30 at the position ① to the position ⑭ use the second arrangement, the accumulated viscoplastic strain performance of the conductive connection portions is good.

When the conductive connection portions 30 at the position ① to the position ⑭ use the third arrangement, the accumulated viscoplastic strain performance of the conductive connection portions is best. When the third arrangement is used, stress of the conductive connection portion 30 may be reduced by 60% to 70% compared with that when the first arrangement is used, and stress of the single conductive connection portion 30 is greatly reduced. This improves a temperature impact resistance capability of the component in a temperature cycling process.

In addition, by comparing a shear test result when the conductive connection portions 30 use the first arrangement with a shear test result when the conductive connection portions 30 use the third arrangement, it may be learned that compared with a shear force that is obtained when the first arrangement is used, a shear force is increased by 225% when the third arrangement is used.

Therefore, a plurality of conductive connection portions are disposed on a single pad, so that stability of the component is improved, and a temperature cycling resistance capability of the component is also greatly improved.

In addition, when a distance between the plurality of conductive connection portions on the single pad is less than or equal to a diameter of the conductive connection portion, stress of the single conductive connection portion is effectively reduced. This improves the temperature impact resistance capability of the component in the temperature cycling process; and an arrangement density of soldering balls is higher. The smaller the distance, the more significant the stress reduction of the single conductive connection portion 30.

It may be learned from performing simulated reflow soldering on the component that when the conductive connection portions 30 use the third arrangement, when a quantity of times of simulated reflow soldering is greater than a quantity of times when the first arrangement is used, the packaging assembly may perform simulated reflow soldering, so that the temperature cycling resistance performance of the component is better, and reliability of the component is significantly improved.

It may be learned that when the distance between the plurality of conductive connection portions on the single pad is less than or equal to the diameter of the conductive connection portion, a quantity of times of simulated reflow soldering performed by the packaging assembly may be increased, the temperature cycling resistance performance of the component is better, and the reliability of the component is significantly improved. The smaller the distance, the more significant the increase in the quantity of times of simulated reflow soldering performed by the packaging assembly.

In addition, embodiments of this application further provide an improved packaging assembly, to implement backup of electrical performance of the component, and improve stability of electrical connection of the component.

As shown in FIG. 14, FIG. 15, and FIG. 16, the packaging assembly includes: a substrate 10, a chip 20, an electrode 101 disposed on the substrate 10, a signal transmission port 102, a pad 201 disposed on the chip 20, and a conductive connection portion 30.

For a structure and a connection relationship between the substrate 10, the chip 20, the electrode 101, the pad 201, and the conductive connection portion 30, refer to the foregoing embodiment. Details are not described herein again.

Based on the foregoing embodiment, at least one pad 201 is connected to a plurality of conductive connection portions 30, and the plurality of conductive connection portions 30 connected to one pad 201 are electrically connected to one signal transmission port 102.

Therefore, compared with the packaging assembly shown in FIG. 5 and FIG. 6, in this embodiment, the plurality of conductive connection portions 30 connected to one pad 201 are electrically connected to one signal transmission port 102, so that electrical performance of the plurality of conductive connection portions connected to one pad 201 is the same, and the plurality of conductive connection portions back up each other's performance. This provides a plurality of performance guarantees.

A connection manner between the plurality of conductive connection portions 30 and one signal transmission port 102 is not limited in embodiments of this application.

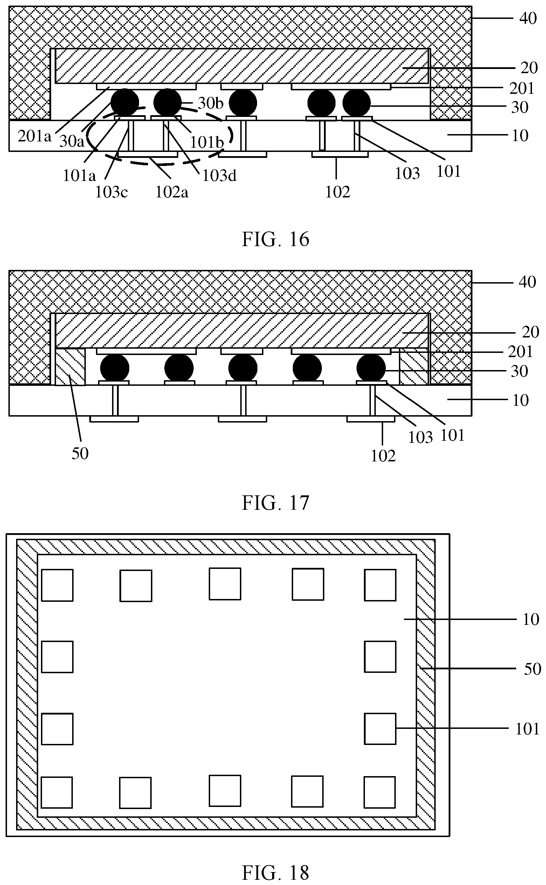

The plurality of conductive connection portions connected to one pad 201 are interconnected on a first surface of the substrate 10 through the electrode 101 (for example, as shown in the dashed line part in FIG. 14), or may be interconnected on the substrate 10 (for example, as shown in the dashed line part in FIG. 15), or may be interconnected on a second surface of the substrate 10 (for example, as shown in the dashed line part in FIG. 16).

In some embodiments, the plurality of conductive connection portions 30 connected to one pad 201 are connected to one electrode 101, and are connected to one signal transmission port 102 through one electrode 101.

As shown in FIG. 14, a pad 201a is connected to two conductive connection portions (a conductive connection portion 30a and a conductive connection portion 30b), the two conductive connection portions (the conductive connection portion 30a and the conductive connection portion 30b) connected to the pad 201a are connected to one electrode 101a, and the electrode 101a is connected to a signal transmission port 102a through a plated through hole 103a.

A signal transmitted by the signal transmission port 102a may be transmitted to the electrode 101a through the plated through hole 103a, and then may be divided into two paths of signals. The two paths of signals are respectively transmitted to the pad 201a through the conductive connection portion 30a and the conductive connection portion 30b, and are finally transmitted to the chip 20 through the pad 201a.

It should be noted that electrical performance of the conductive connection portion 30a and electrical performance of the conductive connection portion 30b are the same, and the conductive connection portion 30a and the conductive connection portion 30b back up each other's performance. When one of the conductive connection portions is disconnected due to a fault, the signal may be further transmitted through another conductive connection portion. This improves stability of the component.

Therefore, the plurality of conductive connection portions connected to one pad 201 are interconnected on the first surface of the substrate 10 through the electrode 101. This implements electrical performance backup of the component.

In some other embodiments, as shown in FIG. 15 and FIG. 16, a plated through hole 103 is disposed in a substrate 10, and a plurality of conductive connection portions 30 connected to one pad 201 are respectively soldered and connected to a plurality of electrodes 101. The plurality of electrodes 101 connected to one pad 201 are electrically connected to one signal transmission port 102 through the plated through hole 103.

In some embodiments, the plurality of electrodes 101 connected to one pad 201 are connected through the plated through hole 103. A plurality of plated through holes 103 connected to one pad 201 are combined into one path in the substrate 10, and are electrically connected to one signal transmission port 102.

As shown in FIG. 15, the pad 201a is connected to two conductive connection portions (a conductive connection portion 30a and a conductive connection portion 30b). The conductive connection portion 30a is connected to an electrode 101a, and the conductive connection portion 30b is connected to an electrode 101b. The electrode 101a is connected to a signal transmission port 102a through a plated through hole 103a, and the electrode 101b is connected to a plated through hole 103b. The plated through hole 103a and the plated through hole 103b are connected in the substrate 10 and are combined into one path.

A signal transmitted by the signal transmission port 102a may be divided into two paths of signals in the substrate. One path of signal is transmitted to the electrode 101a through the plated through hole 103a, and is then transmitted from the electrode 101a to the conductive connection portion 30a. The other path of signal is transmitted to the electrode 101b through the plated through hole 103b, is transmitted from the electrode 101b to the conductive connection portion 30b, then is transmitted from the conductive connection portion 30a and the conductive connection portion 30b to the pad 201a, and is finally transmitted from the pad 201a to the chip 20.

It should be noted that electrical performance of the conductive connection portion 30a and electrical performance of the conductive connection portion 30b are the same, and the conductive connection portion 30a and the conductive connection portion 30b back up each other's performance. When one of the conductive connection portions is disconnected due to a fault, the signal may be further transmitted through another conductive connection portion. This improves stability of the component.

Therefore, the plurality of conductive connection portions connected to one pad 201 are interconnected in the substrate 10 through the plated through hole 103. This implements electrical performance backup of the component.

In some other embodiments, the plurality of electrodes 101 connected to one pad 201 are electrically connected to one signal transmission port 102 through the plurality of plated through holes 103.

As shown in FIG. 16, the pad 201a is connected to two conductive connection portions (a conductive connection portion 30a and a conductive connection portion 30b). The conductive connection portion 30a is connected to an electrode 101a, and the conductive connection portion 30b is connected to an electrode 101b. The electrode 101a is connected to the signal transmission port 102a through a plated through hole 103c, and the electrode 101b is connected to the signal transmission port 102a through a plated through hole 103d.

A signal transmitted by the signal transmission port 102a may be divided into two paths of signals on the second surface of the substrate 10. One path of signal is transmitted to the electrode 101a through the plated through hole 103c. The other path of signal is transmitted to the electrode 101b through the plated through hole 103d, then is transmitted from the electrode 101a to the conductive connection portion 30a, is transmitted from the electrode 101b to the conductive connection portion 30b, is transmitted from the conductive connection portion 30a and the conductive connection portion 30b to the pad 201a, and is finally transmitted from the pad 201a to the chip 20.

Therefore, the plurality of conductive connection portions connected to one pad 201 are interconnected on the second surface of the substrate 10 through the signal transmission port 102. This implements electrical performance backup of the component.

In addition, stability of the component is further improved. In some embodiments, as shown in FIG. 17 and FIG. 18, there is a circle of metal frame 50 between a chip 20 and a substrate 10. The metal frame 50 is, for example, a copper frame. The metal frame 50 is disposed on the substrate 10, for example, and the metal frame 50 and the chip 20 are disconnected.

When a tin ball is used as a conductive connection portion 30, the metal frame 50 may be used to support the chip 20, to facilitate limiting of the melted tin solder material. A thickness of the metal frame 50 determines a height of the solidified tin ball, to facilitate control of a size of the tin ball.

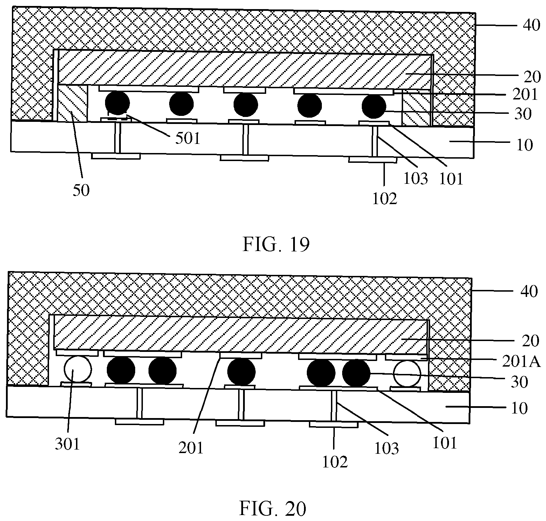

However, as shown in FIG. 19, when a gold ball is used as a conductive connection portion 30, ultrasonic melting needs to be first performed on a gold wire on a chip 20, to form the conductive connection portion 30, and then the chip 20 is inverted on a substrate 10 for ultrasonic welding. In the process, because there is a specific error in a height of the metal frame 50, a gap 501 exists between the conductive connection portion 30 and the substrate 10. As a result, the conductive connection portion 30 and the substrate 10 cannot be effectively contacted to complete ultrasonic soldering. This affects soldering quality, and reduces stability of a component.

Therefore, this application provides an improved packaging assembly, and the packaging assembly may be used in a gold ball process.

As shown in FIG. 20, FIG. 21, and FIG. 22, the packaging assembly includes: a substrate 10, a chip 20, an electrode 101 disposed on the substrate 10, a signal transmission port 102, a pad 201 disposed on the chip 20, and a conductive connection portion 30.

For a structure and a connection relationship between the substrate 10, the chip 20, the electrode 101, the pad 201, and the conductive connection portion 30, refer to the foregoing embodiment. Details are not described herein again.

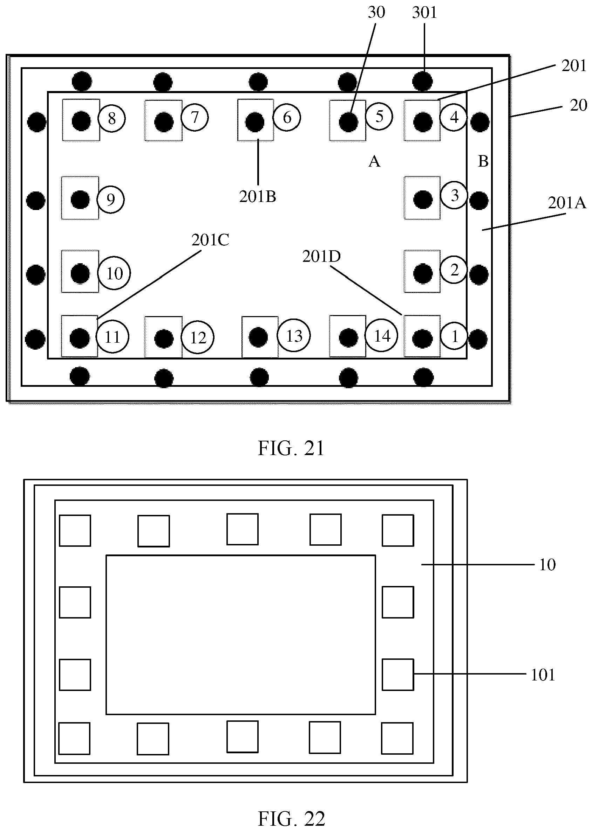

Based on the foregoing embodiment, as shown in FIG. 20 and FIG. 21, a pad 201A is further disposed on a surface of a chip 20, and the packaging assembly further includes: a support component 301 disposed between the chip 20 and a substrate 10. One end of the support component 301 is connected to the pad 201A, and the other end of the support component 301 is connected to an electrode 101. The support component 301 is not connected to a signal transmission port 102. In other words, the electrode 101 connected to the support component 301 is not connected to the signal transmission port 102.

When a gold ball is used as the support component 301, ultrasonic melting may be first performed on a gold wire on the chip 20, to form a conductive connection portion 30 and the support component 301, and then the chip 20 is inverted on the substrate 10 for ultrasonic soldering.

In the process, because a same process is used for the conductive connection portion 30 and the support component 301, a height of the conductive connection portions 30 and a height of the support component 301 are the same, so that the conductive connection portion 30 and the substrate 10 may be effectively contacted to complete ultrasonic soldering. This improves soldering quality, and improves stability of the component.

An arrangement position of the support component 301 is not limited in embodiments of this application. In some embodiments, as shown in FIG. 21, a support component 301 is disposed in a peripheral area of a chip 20. An area enclosed by the pad 201 connected to the signal transmission port 102 is, for example, an effective area A. An area between the effective area A and an edge of the chip 20 is, for example, a peripheral area B of the chip 20, and the pad 201A is, for example, disposed in the peripheral area B.

A pad 201B, a pad 201C, and a pad 201D in FIG. 21 are configured to be connected to a signal end. A rectangular area enclosed after the pad 201B, the pad 201C, and the pad 201D are connected may be used as the effective area A, the pad 201A is located in the peripheral area B, and the support component 301 is connected to the pad 201A.

Optionally, each signal transmission port 102 is connected to one pad 201. In one packaging assembly, a quantity of signal transmission ports N meets: N≥2.

Optionally, a peripheral area may be an annular area enclosed by a boundary of the effective area A and an edge of the chip. For example, as shown in FIG. 21, when a surface of a chip is rectangular, a boundary of an effective area A is also rectangular, and the boundary of the effective area A and the edge of the chip enclose a square ring.

In some other embodiments, a surface of the chip is in a shape of a circle, the boundary of the effective area A is also in a shape of a circle, and the boundary of the effective area A and the edge of the chip enclose a ring.

Therefore, the boundary of the effective area A and the edge of the chip enclose a regular ring, so that conductive connection portions are evenly disposed on the edge of the chip, and stability of the packaging assembly is improved.

It should be noted that the boundary of the effective area A and the peripheral area B may also be in irregular shapes, and all these fall within the protection scope of this application.

A manner of sorting the support components 301 in the peripheral area B is not limited in embodiments of this application. The support components 301 may be continuously arranged or may be discontinuously arranged. When the support components 301 are discontinuously arranged, the plurality of support components 301 may be distributed at an equal interval, or may not be distributed at an equal interval.

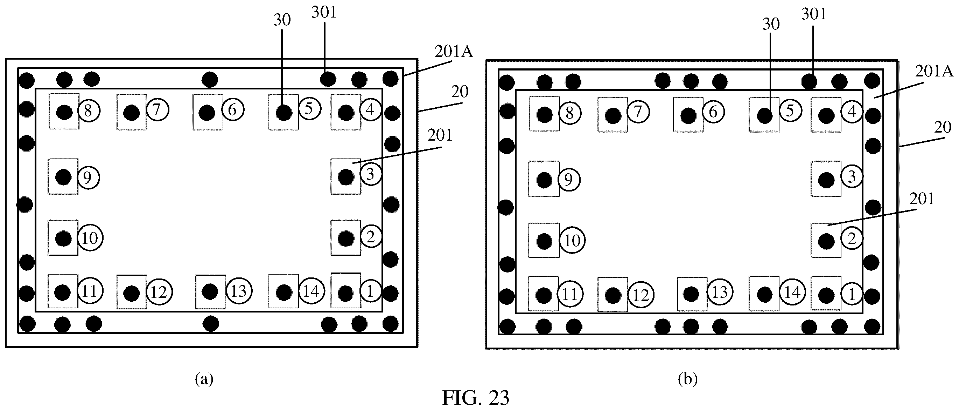

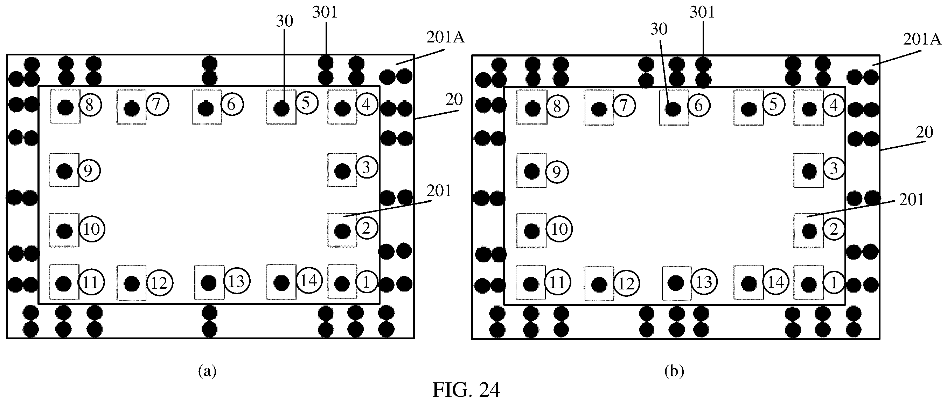

As shown in FIG. 23 and FIG. 24, spacings between a plurality of support components 301 are different.

In addition, the support components 301 may use single-layer arrangement, or may use multi-layer arrangement, where stability of the multi-layer arrangement is higher.

As shown in (a) and (b) in FIG. 23, the support components 301 use the single-layer arrangement.

As shown in (a) and (b) in FIG. 24, the support components 301 use dual-layer arrangement.

In some other embodiments, the support components 301 may be disposed in an effective area A of a chip 20, and are spaced apart from the conductive connection portion 30 (not shown in the figure).

In other embodiments, a part of support components 301 are disposed in the effective area A of the chip 20, and a part of support components 301 are disposed in a peripheral area B of the chip 20 (not shown in the figure).

Shapes of the support components 301 are not limited in embodiments of this application. The support components 301 may use a same shape as the foregoing conductive connection portion 30. For example, the shapes of the support components 301 may be a sphere, an ellipse, and a cube.

Materials of the support components 301 are not limited in embodiments of this application. The support components 301 are made of metal or an alloy material. Preferably, a gold ball may be used as the support component 301. When the packaging assembly is produced, the support component 301 may be formed by using a same process as the conductive connection portion 30.

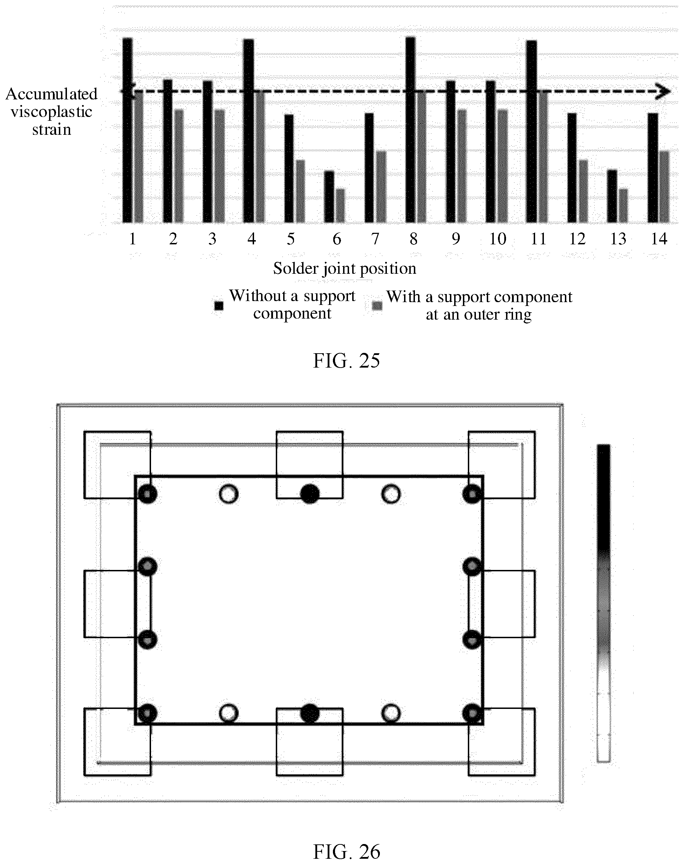

FIG. 25 is a simulation diagram of accumulated viscoplastic strain of a packaging assembly according to an embodiment of this application. FIG. 25 shows a comparison of the accumulated viscoplastic strain of a conductive connection portion 30 of the packaging assembly at a position ① to a position ⑭ when there is no support component 301 and there is a support component 301 at an outer ring in a peripheral area.

As shown in FIG. 25, when there is no support component 301, the conductive connection portion may use the first arrangement in the foregoing embodiment (as shown in (a) in FIG. 12), and the accumulated viscoplastic strain of the conductive connection portion 30 at the position ① to the position ⑭ is large.

When there is a support component 301 at the outer ring in the peripheral area, the accumulated viscoplastic strain of the conductive connection portion 30 at the position ① to the position ⑭ is small.

Therefore, it may be learned from the foregoing simulation that by disposing the support component in the peripheral area, stress on a single conductive connection portion is weakened. Compared with a case in which no support component is disposed, the stress on the single conductive connection portion may be reduced by 30%. This may improve a deformation resistance capability of a component in a temperature cycling process.

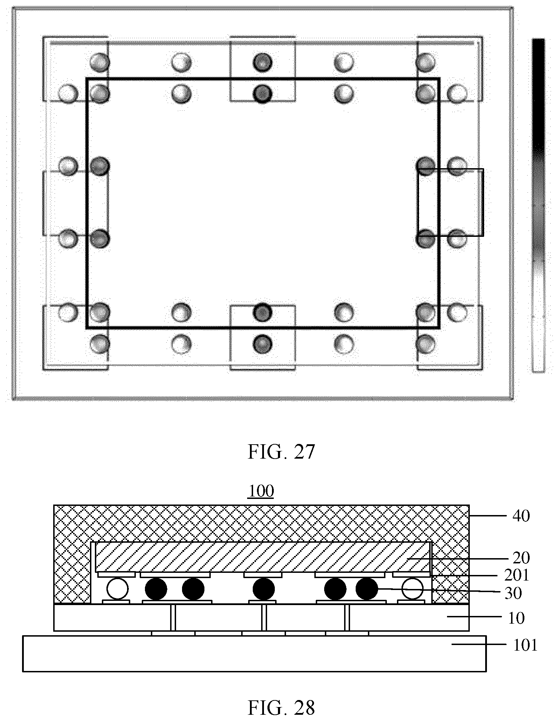

In addition, FIG. 26 is a simulation diagram of compressive performance of each conductive connection portion without a support component. FIG. 27 is a simulation diagram of compressive performance of each conductive connection portion when there is a support component 301 at an outer ring in a peripheral area. As shown in FIG. 26 and FIG. 27, comparing a case in which there is a support component at the outer ring in the peripheral area with a case in which there is no support component at the outer ring in the peripheral area, the stress on the single conductive connection portion is reduced by 44%.

Therefore, it may be learned from the foregoing simulation that by disposing the support component in the peripheral area, the stress on the single conductive connection portion may be reduced, and a risk of fracturing of the chip and the conductive connection portion may be reduced.

Embodiments of this application further provide an electronic device. FIG. 28 is a schematic diagram of a cross-sectional structure of an electronic device 100 according to this application. The electronic device 100 includes, for example, a circuit board 101 and a packaging assembly disposed on the circuit board 101. A signal transmission port 102 of the packaging assembly is soldered to the circuit board 101.

A structure and a function of the packaging assembly 20 are the same as a structure and a function of the packaging assembly 20 in the foregoing embodiment, and details are not described herein again.

The electronic device may be a surface acoustic wave filter (Surface Acoustic Wave Filter, SAW filter), a film bulk acoustic resonator filter (Film Bulk Acoustic Resonator Filter, FBAR filter), a bulk acoustic wave filter (Bulk Acoustic Wave Filter, BAW filter), or an interdigital transducer (Interdigital Transducer, IDT).

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A packaging assembly, comprising: a substrate and a chip, wherein
the substrate comprises a first surface and a second surface that are opposite to each other, the first surface of the substrate is opposite to a surface of the chip, a plurality of electrodes are disposed on the first surface of the substrate, a signal transmission port is disposed on the second surface of the substrate, and the signal transmission port is connected to the electrode; and
a first pad is disposed on the surface of the chip, and the first pad is connected to the electrode through a conductive connection portion, wherein
the first pad is connected to a plurality of conductive connection portions, and the plurality of conductive connection portions are connected to one signal transmission port.

2. The packaging assembly according to claim 1, wherein that the plurality of conductive connection portions are connected to one signal transmission port comprises:
the plurality of conductive connection portions are connected to one electrode, and are connected to one signal transmission port through one electrode.

3. The packaging assembly according to claim 1, wherein that the plurality of conductive connection portions are connected to one signal transmission port comprises:
a plurality of plated through holes are provided in the substrate, and
the plurality of conductive connection portions are respectively connected to the plurality of electrodes, and the plurality of electrodes are respectively connected to the signal transmission port through the plurality of plated through holes.

4. The packaging assembly according to claim 3, wherein the plurality of plated through holes are combined into one path in the substrate, and are connected to one signal transmission port.

5. The packaging assembly according to any one of claims 1 to 4, wherein a distance between adjacent conductive connection portions in the plurality of conductive connection portions is less than or equal to a diameter of a single conductive connection portion.

6. The packaging assembly according to any one of claims 1 to 5, wherein the first pad is in a shape of a circle or a polygon.

7. The packaging assembly according to any one of claims 1 to 6, wherein connection lines of centers of the plurality of conductive connection portions connected to one first pad are arranged in a shape of a straight line, a broken line, or a polygon.

8. The packaging assembly according to any one of claims 1 to 7, wherein the conductive connection portion is in a shape of a sphere, an ellipse, a cube, or a polyhedron.

9. The packaging assembly according to any one of claims 1 to 8, wherein the conductive connection portion is made of metal or an alloy material.

10. The packaging assembly according to any one of claims 1 to 9, wherein
a second pad is disposed on the surface of the chip; and
a support component is disposed between the chip and the substrate, one end of the support component is connected to the second pad, the other end of the support component is connected to the electrode, and the support component is not connected to the signal transmission port.

11. The packaging assembly according to claim 10, wherein the support component is disposed in a peripheral area of the chip.

12. The packaging assembly according to claim 11, wherein an area between an effective area of the chip and an edge of the chip is the peripheral area of the chip.

13. The packaging assembly according to any one of claims 10 to 12, wherein the support component is spaced apart from the conductive connection portion.

14. The packaging assembly according to any one of claims 10 to 13, wherein the support component is in a shape of a sphere, an ellipse, a cube, or a polyhedron.

15. The packaging assembly according to any one of claims 10 to 14, wherein the support component is made of metal or an alloy material.

16. The packaging assembly according to any one of claims 1 to 15, wherein the packaging assembly further comprises a housing, the housing and the first surface of the substrate enclose a first cavity, and the chip is located in the first cavity.

17. The packaging assembly according to claim 16, wherein the housing comprises: a bracket and a cover plate, wherein the bracket is located on the first surface of the substrate and surrounds the chip, and the cover plate is disposed on a top of the bracket.

18. An electronic device, wherein the electronic device comprises a circuit board and the packaging assembly according to any one of claims 1 to 17, and a signal transmission port of the packaging assembly is soldered on the circuit board.
